# EUROPÄISCHE PATENTSCHRIFT

(11) **EP 1 368 882 B1**
(45) Veröffentlichungstag und Bekanntmachung des Hinweises auf die Patenterteilung: **09.02.2005**
(21) Anmeldenummer: 02730016.9
(22) Anmeldetag: 15.03.2002
(51) Int. Cl.: H02K 11/04, H02K 9/19, H02K 5/20

(54) **FLUIDGEKÜHLTE ELEKTRISCHE MASCHINE**
FLUID COOLED ELECTRIC MACHINE
MACHINE ELECTRIQUE A REFROIDISSEMENT FLUIDIQUE

(30) Priorität: 16.03.2001 DE 10112799
(43) Veröffentlichungstag der Anmeldung: 10.12.2003
(73) Patentinhaber: Compact Dynamics GmbH, 82319 Starnberg (DE)
(72) Erfinder: GRÜNDL, Andreas, 81377 München (DE); HOFFMANN, Bernhard, 82319 Starnberg (DE)
(74) Vertreter: Schmidt, Steffen J., Dipl.-Ing.
(86) Internationale Anmeldenummer: PCT/EP2002/002909
(87) Internationale Veröffentlichungsnummer: WO 2002/075901

(56) Entgegenhaltungen:
- DE-A- 2 325 771
- DE-A- 3 941 474
- US-A- 3 562 564

## Beschreibung

### Hintergrund der Erfindung

Die Erfindung betrifft eine fluidgekühlte elektrische Maschine mit einem Gehäuse, in dem ein Stator und ein Rotor, mit Stator- und/oder Rotorspulen angeordnet sind, wobei die elektrische Maschine mit einer an ihrem Umfang angeordneten Kühleinrichtung wärmeleitend gekoppelt ist, und mit einer elektronischen Leistungsansteuerung verbunden ist. Fluidgekühlte Maschinen werden je nach Einsatzgebiet entweder mit Öl oder mit Wasser gekühlt, wobei das Fluid durch eine Pumpe gefördert wird, die entweder durch die elektrische Maschine selbst oder durch einen separaten Antrieb betätigt wird.

### Begriffsdefinitionen

Unter einer elektrischen Maschine wird hierbei eine elektrische Maschine in Form einer Innen- oder Außenläufermaschine verstanden. Eine elektrische Maschine kann hierbei sowohl ein elektrischer Motor als auch ein elektrischer Generator sein. Die Erfindung kommt insbesondere bei Drehmaschinen aller Art (Synchron-, Asynchron-, Reluktanzmaschinen, Permanenterregte Maschinen oder dergl.) zum Einsatz.

### Stand der Technik

Im Stand der Technik ist es bekannt, elektrische Maschinen, insbesondere Wechselfeldmaschinen, mit sog. Frequenzumrichtern zu betreiben. Üblicherweise enthalten diese Frequenzumrichter eine der Anzahl der Phasen der elektrischen Maschine entsprechende Anzahl von Halbbrückenanordnungen, die von einer Ansteuerelektronik mit Steuersignalen gespeist wird. Damit wird - je nach dem ob die elektrische Maschine als Motor oder als Generator betrieben wird - die elektrische Leistung der elektrischen Maschine entweder für die gewünschte Drehzahl und das gewünschte Drehmoment zugeführt oder der elektrischen Maschine die elektrische Leistung entnommen und für den nachgeschalteten Verbraucher in die gewünschte Betrags- und Phasenlage umgesetzt. Dabei sind die Frequenzumrichter separat von den elektrischen Maschinen angeordnet und mit diesen über mehrphasige Leistungskabel verbunden.

Ein Beispiel ein der derartigen Konfiguration einer Leistungselektronik für eine elektrische Maschine ist in der DE 42 30 510 A1 beschrieben. Hierbei wird das Konzept verfolgt, die Elektronik in einer Siedebadkühlung anzuordnen, wobei dieser druckdicht gekapselten Anordnung die Stromzuführungen, die Ansteuersignale für die Steuerelektronik etc. über eine zentrale Öffnung im Boden der Kapsel zugeführt werden.

Aus der DE 43 11 518 A1 ist eine Antriebseinrichtung für ein Fahrzeug mit einem über einen Umrichter gespeisten elektrischen Antriebsmotor bekannt. Am Außenumfang des Antriebsmotors sind an einem Gehäuse des Antriebsmotors anliegende Kühlrohre angeordnet. Bauelemente des Umrichters sind auf zwei getrennt am Gehäuse des Antriebsmotors angeordnete Baugruppen verteilt und stehen jeweils über eine Basisplatte, welche auf den Kühlrohren des Antriebsmotors aufliegt, in wärmeleitender Verbindung mit diesen Kühlrohren.

Aus der DE 39 41 474 A1 ist ein flüssigkeitsgekühlter elektrischer Generator mit zwei Ständerwicklungen bekannt, die jeweils mit eigenen Gleichrichterblöcken elektrisch verbunden sind.

Die DE 196 45 635 C1 offenbart ein Steuergerät zur Ansteuerung des Elektromotors von Kraftfahrzeugen, bei dem in einem Gehäusekörper integrierte Funktionseinheiten als separate Funktionsmodule ausgebildet sind und sowohl funktionell als auch räumlich voneinander separiert sind.

Die DE 42 17 289 A1 offenbart eine fluidgekühlte Leistungstransistoranordnung mit mehreren Halbleiterelementen, die nebeneinander, in Form von einer oder mehreren Halboder Vollbrücken modulartig aufgebaut sind.

Aus der DE 40 38 663 A1 ist eine Wechselstromlichtmaschine für Fahrzeuge mit einer Kühleinrichtung bekannt, wobei die Kühleinrichtung eine Umlaufbahn für Kühlflüssigkeit aufweist, die innen einen Fließweg hat und von außen mit Kühlflüssigkeit beliefert werden kann. An einer Außenfläche der Umlaufbahn sind ein Gleichrichter und ein Spannungsregler angeordnet.

Die DE 41 31 463 A1 offenbart einen Wechselstromgenerator für ein Kraftfahrzeug mit einem Gehäuse, welches sich im Inneren einer Wanne mit Zu- und Ableitungen für eine Kühlflüssigkeit befindet. Ein Deckel des Gehäuses weist Durchtritte für die Kühlflüssigkeit auf, wobei eine Gleichrichtereinheit und ein Regler an der Außenseite des Deckels gegenüber den Durchtritten befestigt sind.

Die DE 42 44 721 A1 offenbart eine elektrische Maschine, deren Wicklungen in Wärmetauschkontakt mit einer FluidKühlanordnung stehen. Die Kühlanordnung erzeugt in einem mit den Wicklungen zu einer Baueinheit vereinigten Kühlfluidkanal eine Zwangsströmung eines Kühlfluids.

Die DE- A-2 325 771 offenbart eine fluidgekühlte elektrische Maschine entsprechend dem Oberbegriff des Anspruchs 1.

Problematisch ist hierbei vor allem der Verkabelungsaufwand und die durch die Leitungen zwischen der elektrischen Maschine und dem Frequenzumrichter erforderliche elektromagnetische Abschirmung. Außerdem fällt ein erheblicher Bedarf an Leistungssteckverbindern sowohl auf der Seite des Frequenzumrichters als auch auf der Seite der elektrischen Maschine an. Auch die Kühlung der Leistungselektronik des Frequenzumrichters erfordert nennenswerten Aufwand. Ein weiteres Problem besteht darin, dass die Reparatur eines solchen gekapselten Frequenzumrichters praktisch nicht möglich ist ohne die druckdichte Kapsel zu öffnen. Das Verschließen der Kapsel ist nur mit erheblichem Aufwand möglich. Damit führen selbst geringfügige Defekte an dem gekapselten Frequenzumrichter dazu, dass dieser nur als Ganzes ausgetauscht werden kann.

### Der Erfindung zugrundeliegendes Problem

Der Erfindung liegt daher das Problem zugrunde, elektrische Maschinen der eingangs genannten Art, die die obigen Nachteile vermeiden und eine kompakte, kostengünstig herstellbare und im Betrieb zuverlässige Anordnung bereitstellen.

### Erfindungsgemäße Lösung

Die gestellte Aufgabe wird durch eine fluidgekühlte elektrische Maschine mit den Merkmalen des Anspruchs 1 gelöst.

Bei Innenläufermaschinen ist die Kühleinrichtung am äußeren Umfang der elektrischen Maschine angeordnet, wobei die Module der elektronischen Leistungsansteuerung an der Kühleinrichtung radial außenliegend angeordnet sind. Bei Außenläufermaschinen wird die Kühlung des innenliegenden Stators und dessen Spulen durch eine innenliegende (ringzylinderförmige) Kühleinrichtung bewirkt, an deren Innenumfang die Module angeordnet sind. Die Kühleinrichtung ist von Fluidkanälen durchzogen. Diese können die elektrische Maschine entweder wendelförmig umgeben oder im wesentlichen koaxial zur Rotationsachse der elektrischen Maschine verlaufen.

Dabei hat die Kühleinrichtung an ihrer Außen- oder Innenwand wenigstens eine zu wenigstens einem der Fluidkanäle reichende Öffnung, in die an einem der Module der elektronischen Leistungsansteuerung angeordnete Kühlelemente hineinragen. Diese Kühlelemente können zum Beispiel rippen-, steg-, oder stiftförmig ausgestaltet sein.

Anstatt wie bisher die Leistungs-Ansteuerelektronik für die elektrische Maschine von dieser getrennt anzuordnen und zu kühlen, beschreitet die erfindungsgemäße Lösung den Weg, die elektrische Maschine und die Leistungs-Ansteuerelektronik zu integrieren und durch die gleiche Kühleinrichtung zu kühlen. Dies spart erheblich Platz und Kosten. Außerdem ist es bei einer ggf. notwendigen Reparatur erheblich einfacher und kostengünstiger, lediglich ein oder mehrere defekte Module, und nicht die Leistungs-Ansteuerelektronik als Ganzes auszutauschen. Weiterhin erlaubt die Erfindung, den Abschirmungsaufwand gegen elektromagnetische Störstrahlung erheblich zu reduzieren, da die hochfrequente Leistung führenden Leitungen sehr viel kürzer als bei herkömmlichen - getrennten - Anordnungen sind. Außerdem reduziert sich der Verschaltungsaufwand erheblich, da die bisher üblichen Phasenverteilerschienen auf der Maschinenseite entfallen können.

Die Kühleinrichtung kann in das Gehäuse der elektrischen Maschine bereits bei dessen Herstellung integriert sein. Dies ist zum Beispiel bei Gehäusen aus Gusseisen relativ einfach möglich, da hierbei die Kühleinrichtung mit ihren Fluidkanälen an der Wandung des Gehäuses auf einfache Weise ausgeformt werden kann. Vorzugsweise ist der Statorträger mit der integrierten Kühlung aus Eisen gefertigt; insbesondere wenn die elektrische Maschine als Hilfsantrieb in einem KFZ eingesetzt wird, da hierbei ein BetriebsTemperaturbereich von -35°C/+150°C sichergestellt werden muss.

Zur Verbesserung der Wärmeableitung sowohl aus der elektrische Maschine als auch von den Modulen der elektronischen Leistungsansteuerung sind die in die Fluidkanäle hineinragenden Kühlelemente so gestaltet, dass sie in dem in den Fluidkanälen strömenden Fluid turbulente Strömungen verursachen. Dies erfolgt zum Beispiel durch quer zum Fluidstrom angeordnete Prallplatten, aufeinander zu oder voneinander weg orientierte Leitschaufeln oder dergl.

Für eine gute elektrische Isolierung und eine gleichzeitige gute thermische Ankopplung der in den Modulen der elektronischen Leistungsansteuerung befindlichen Leistungshalbleiter (MOS-FETs, IGBTs, Schottky-Dioden etc.) sind die in die Fluidkanäle hineinragenden Kühlelemente und/oder die Abdeckungen der Module aus Nicht-Eisenmetall, vorzugsweise Kupfer oder Aluminium enthaltendem Material, oder aus Keramik, vorzugsweise aus Aluminiumoxid, Aluminiumnitrid, und/oder Siliziumkarbid enthaltendem Material gebildet. Die Materialkombination ist dabei so zu wählen, dass eine Isolierung gegen den Kühlmantel bzw. das Kühlfluid möglich ist. In einer besonders vorteilhaften Ausführungsform sind die in die Fluidkanäle hineinragenden Kühlelemente und/oder die Abdeckungen der Module aus ein- oder beidseitig mit Metall, zum Beispiel Kupfer beschichtetem Keramikmaterial mit aufgesetzten oder angeformten Kühlfahnen gebildet.

Um die in den Modulen befindlichen Komponenten der elektronischen Leistungsansteuerung mit den Stator- und/oder Rotorspulen auf möglichst kurzem Wege zu verbinden, sind in dem Gehäuse im wesentlichen radial orientierte Leitungen angeordnet, welche von den Stator- und/oder Rotorspulen zu den jeweiligen Modulen der elektronischen Leistungsansteuerung reichen.

Weiterhin sind in oder an dem Gehäuse im wesentlichen entlang des Umfangs orientierte Leitungen angeordnet, welche die jeweiligen Module der elektronischen Leistungsansteuerung miteinander verbinden. Damit können zum einen Ansteuersignale und zum anderen die erforderliche elektrische Leistung an die Module verteilt werden (im Motorbetrieb) bzw. von den einzelnen Modulen abgegriffen werden (im Generatorbetrieb).

### Kurzbeschreibung der Zeichnung

In der Zeichnung sind Details der Erfindung in unterschiedlichen Ausführungsformen veranschaulicht.

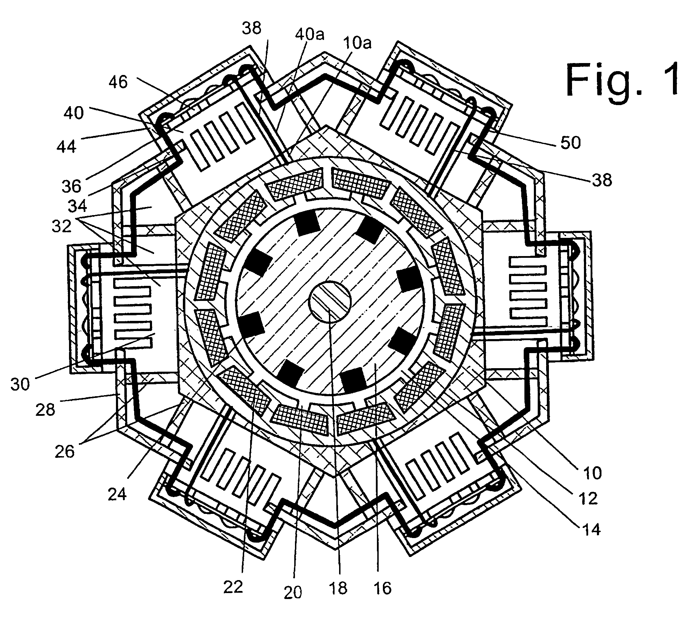

Fig. 1 zeigt eine schematische Querschnittsanicht durch eine fluidgekühlte elektrische Maschine gemäß der Erfindung.

### Detaillierte Beschreibung der Zeichnung

Die in Fig. 1 veranschaulichte fluidgekühlte elektrische Maschine ist eine als Innenläufer ausgebildete Drehfeldmaschine. Diese Maschine hat ein Gehäuse 10, in dem ein Stator 12 und, durch einen Luftspalt 14 getrennt, ein Rotor 16 mit einer Welle 18 angeordnet sind. Der Stator 12 ist durch übereinander gestapelte Bleche gebildet und hat zur Innenumfangsfläche hin offene Nuten 20 zur Aufnahme von nur angedeuteten Statorspulen 22. Der Rotor 16 ist ebenfalls durch übereinander gestapelte Bleche gebildet und hat entlang seines Außenumfangs gleichmäßig verteilte, zur Welle 18 koaxiale Stäbe 24 eines Kurzschlusskäfigs.

Das Gehäuse 10 hat an seiner Außenseite im wesentlichen radiale Stege 26, die zusammen mit der Außenseite des Gehäuses 10 und einer Ummantelung 28 eine Kühleinrichtung 30 bilden. Diese Kühleinrichtung 30 hat koaxial zur Welle 18 orientierte Kühlkanäle 32. Die elektrische Maschine bzw. deren Stator 12 ist über die Außenseite des Gehäuses 10 mit den Kühlkanälen 32 der Kühleinrichtung 30 thermisch gekoppelt. In den Kühlkanälen 32 der Kühleinrichtung 30 zirkuliert Wasser oder Öl, das die von der elektrische Maschine abgegebene Wärmeenergie in einem nicht weiter veranschaulichten Wärmetauscher an die Umgebung abgibt.

Die Ummantelung 28 der Kühleinrichtung 30 hat mehrere Öffnungen 34, durch die jeweils ein Modul 36 einer elektronische Leistungsansteuerung ragt. Jedes der Module 36 ist mit einer der Statorspulen 22 durch eine im wesentlichen radial orientierte Leitung 38 elektrisch verbunden.

Die Module 36 sind entsprechend den Öffnungen 34 am Umfang der elektrischen Maschine verteilt angeordnet und mit der Kühleinrichtung 30 durch in die Kühlkanäle 32 ragende Kühlelemente 40 wärmeleitend gekoppelt. Die Kühlelemente 40 sind so gestaltet, dass sie in dem in den Fluidkanälen 32 strömenden Wasser oder Öl turbulente Strömungen zur Verbesserung der Wärmeabfuhr aus den Modulen 36 der elektronischen Leistungsansteuerung und aus der elektrische Maschine hervorrufen. Die Kühlelemente 40 haben einen Steg 40a, der durch den Fluidkanal 32 in radialer Richtung durch die Aussenwand des Gehäuses 10 in eine Öffnung 10a bis zu dem Stator 12 bzw. der jeweiligen Statorspule 22 reicht. In dem Steg 40a ist die Leitung 38 von dem Modul 36 zu der jeweiligen Statorspule 22 geführt. Alternativ dazu kann die Leitung 38 auch in einem der Stege 26 der Kühleinrichtung 30 von dem Modul 36 zu der jeweiligen Statorspule 22 geführt sein.

Die Module 36 der elektronischen Leistungsansteuerung haben eine im wesentlichen quaderförmige Gestalt und weisen zwischen einer äußeren Abdeckung 44 und dem Kühlelement 40 eine Leistungshalbleiter 46 enthaltende Elektronik auf. Dabei sind die Verlustwärme erzeugenden Leistungshalbleiter 46 mit dem Kühlelement 40 thermisch gekoppelt.

Die Abdeckungen 44 der Module 40 sind aus Kupfer oder Aluminium enthaltendem Material und die Kühlelemente 40 aus Aluminiumoxid, Aluminiumnitrid oder Siliziumkarbid gebildet.

Zwischen der Außenwand des Gehäuses 10 und der Ummantelung 28 sind im wesentlichen entlang des Umfangs orientierte Leitungen 50 für die Zu- bzw. Abfuhr elektrischer Leistung sowie von Steuersignalen zur Koordinierung des Betriebs der Steuerelektronik angeordnet, welche die jeweiligen Module 36 der elektronischen Leistungsansteuerung miteinander verbinden.

An den Durchführungen der Leitungen 38, 50 sind jeweils nicht weiter veranschaulichte Dichtungen vorgesehen. In gleicher Weise sind die Anlageflächen der Kühlelemente 40 an den Öffnungen 34 der Ummantelung 28 mit entsprechenden Dichtungen ausgestattet.

Schließlich sei bemerkt, daß die Zeichnungen nur zur prinzipiellen Darstellung und der Erläuterung der Erfindung dienen; die tatsächlichen Abmessungen und Proportionen von Ausführungsformen der Erfindung können davon abweichen.

## Patentansprüche

1. Eine fluidgekühlte elektrische Maschine mit
- einem Gehäuse (10), in dem ein Stator (12) und ein Rotor (16) mit Stator- und/oder Rotorspulen (22, 24) angeordnet sind, wobei die elektrische Maschine mit
- einer an ihrem Umfang angeordneten Kühleinrichtung (30) wärmeleitend gekoppelt und mit einer elektronischen Leistungsansteuerung verbunden ist,
- wobei die elektronische Leistungsansteuerung in mehrere Module (36) aufgeteilt ist, die jeweils mit wenigstens einer der Stator- und/oder Rotorspulen (22, 24) elektrisch verbunden sind, wobei die Module (36) am Umfang der elektrischen Maschine verteilt angeordnet und an der Kühleinrichtung (30) radial außen- oder innenliegend angeordnet und wärmeleitend gekoppelt sind und von Fluidkanälen (32) derart durchzogen ist, dass die Kühleinrichtung (30) an ihrer Außen- oder Innenwand wenigstens eine Öffnung (34) zu wenigstens einem der Fiuidkanäle (32) aufweist, in die an einem der Module (36) angeordnete Kühtelemente (40) hineinragen, **dadurch gekennzeichnet, daß**
- in oder an dem Gehäuse (10) im wesentlichen entlang des Umfangs orientierte Leitungen (50) angeordnet sind, welche die jeweiligen Module (36) der elektronischen Leistungsansteuerung miteinander verbinden.

2. Fluidgekühlte elektrische Maschine nach dem vorhergehenden Anspruch 1, **dadurch gekennzeichnet, daß**
- die in die Fluidkanäle (32) hineinragenden Kühlelemente (40) so gestaltet sind, dass sie in dem in den Fluidkanälen (32) strömenden Fluid turbulente Strömungen verursachen.

3. Fluidgekühlte elektrische Maschine nach Anspruch 1 oder 2, **dadurch gekennzeichnet, daß**
- die in die Fiuidkanäle (32) hineinragenden Kühlelemente (40) und/oder Abdeckungen (44) der Module (36) aus Nicht-Eisenmetall, vorzugsweise Kupfer oder Aluminium enthaltendem Material, oder aus Keramik, vorzugsweise aus Aluminiumoxid, Aluminiumnitrid, und/oder Siliziumkarbid enthaltendem Material gebildet sind.

4. Fluidgekühlte elektrische Maschine nach einem der vorhergehenden Ansprüche, **dadurch gekennzeichnet, daß**
- in dem Gehäuse (10) im wesentlichen radial orientierte Leitungen (38) angeordnet sind, welche die Stator- und/oder Rotorspulen (22, 24) mit den jeweiligen Modulen (36) der elektronischen Leistungsansteuerung verbinden.

## Claims

1. A fluid-cooled electrical machine comprising
- a housing (10) in which are arranged a stator (12) and a rotor (16) with stator and/or rotor coils (22, 24), wherein the electrical machine is
- coupled heat-conductively with a cooling device (30) arranged on its periphery and connected with an electronic power control,
- wherein the electronic power control is divided into several modules (36) each of which are electrically connected with at least one of the stator and/or rotor coils (22, 24), wherein the modules (36) are arranged distributed on the periphery of the electrical machine and arranged lying radially on the outside or inside of the cooling device (30) and coupled heat conductively thereto, and fluid channels (32) run through the cooling device (30) in such a manner that it has on its outer or inner wall at least one opening (34) for at least one of the fluid channels (32), in which opening protrude cooling elements (40) arranged on one of the modules (36), **characterized in that**
- in or on the housing (10) are arranged lines (50) oriented substantially along the periphery and connecting together the respective modules (36) of the electronic power control.

2. Fluid-cooled electrical machine according to the preceding claim 1, **characterised in that**
- the cooling elements (40) protruding into the fluid channels (32) are designed such that they cause turbulent flows in the fluid flowing in the fluid channels (32).

3. Fluid-cooled electrical machine according to claim 1 or 2, **characterised in that**
- the cooling elements (40) protruding into the fluid channels (32) and/or covers (44) of the modules (36) are made of non-ferrous metal, preferably material containing copper or aluminium, or of ceramic, preferably of aluminium oxide, aluminium nitride and/or material containing silicon carbide.

4. Fluid-cooled electrical machine according one of the preceding claims, **characterised in that**
- in the housing (10) are arranged substantially radially oriented lines (38) which connect the stator and/or rotor coils (22, 24) with the respective modules (36) of the electronic power control.

## Revendications

1. Machine électrique refroidie par fluide, qui comprend:
- un caisson (10) dans lequel sont disposés un stator (12) et un rotor (16) dotés de bobinages de stator et/ou de rotor (22, 24),
- la machine électrique étant accouplée de manière thermiquement conductrice à un dispositif de refroidissement (30) disposé à sa périphérie et reliée à une commande électronique de puissance,
- la commande électronique de puissance étant répartie en plusieurs modules (36) qui sont chacun reliés électriquement à au moins l'un des bobinages (22, 24) du etator et/ou du rotor, les modules (36) étant répartis à la périphérie de la machine électrique, étant disposés sur le côté situé radialement à l'intérieur ou à l'extérieur du dispositif de refroidissement (30) et étant couplés de manière thermiquement conductrice et traversés par des canaux de fluide (32) de telle sorte que sur sa paroi extérieure ou sa paroi intérieure, le dispositif de refroidissement (30) présente au moins une ouverture (34) vers au moins l'un des canaux de fluide (32) dans lesquels pénètrent les éléments de refroidissement (40) disposés sur l'un des modules (36),
**caractérisée en ce que**
dans ou sur le caisson (10) sont disposés des conducteurs (50) qui sont orientés essentiellement dans le sens périphérique et qui relient les uns aux autres chacun des modules (36) de la commande électronique de puissance.

2. Machine électrique refroidie par fluide selon la revendication 1 qui précède, **caractérisée en ce que** les éléments de refroidissement (40) qui pénètrent dans les canaux de fluide (32) sont configurés de manière à provoquer des écoulements turbulents dans le fluide qui pénètre dans les canaux de fluide (32).

3. Machine électrique refroidie par fluide selon la revendication 1 ou 2, **caractérisée en ce que** les éléments de refroidissement (40) qui pénètrent dans les canaux de fluide (32) et/ou des couvercles (44) des modules (36) sont réalisés en un métal non ferreux, de préférence un matériau qui contient du cuivre ou de l'aluminium, ou en céramique, de préférence en un matériau qui contient de l'oxyde d'aluminium, du nitrure d'aluminium et/ou du carbure de silicium.

4. Machine électrique refroidie par fluide selon l'une des revendications précédentes, **caractérisée en ce que** dans le caisson (10) sont disposés des conducteurs (38) orientés essentiellement dans le sens radial et qui relient les bobinages (22, 24) de stator et/ou de rotor à chacun des modules (36) de la commande électronique de puissance.
